# EUROPEAN PATENT APPLICATION

(11) **EP 1 939 516 A2**
(43) Date of publication of application: **02.07.2008**
(21) Application number: 07024447.0
(22) Date of filing: 17.12.2007
(51) Int. Cl.: F16L 59/135, G01R 31/28

(54) **Testing machine and insulated pipe system for a thermal medium**

(30) Priority: 26.12.2006 JP 2006349944
(71) Applicant: Espec Corp., Kita-ku Osaka-shi Osaka 530-8550 (JP)
(72) Inventor: Kurara, Hironobu, Osaka-shi Osaka 530-8550 (JP); Nishikawa, Taihel, Osaka-shi Osaka 530-8550 (JP); Nakanishi, Masataka, Osaka-shi Osaka 530-8550 (JP)
(74) Representative: Albrecht, Ralf

(57) **Abstract**

In one example, a piping system 20 is built around a wire (elongated flexible member) 25. An inlet pipe 21 and an outlet pipe 22 are fixed to both sides of the wire 25 parallel to each other via a plurality of pipe holders 26. Further, insulator holders 27 are attached to the wire 25 and heat insulating sections 28 are attached to the insulator holders 27. A cylindrical gap 51 is formed between the inlet pipe 21 and the inner surface of each of the heat insulating section 28.

## Description

### BACKGROUND OF THE INVENTION

### FIELD OF THE INVENTION

The present invention relates to testing machine for testing performance of semiconductor wafers, such as a so-called wafer probe. The present invention also relates to a piping system for supplying a thermal medium to a thermostat incorporated in the above-mentioned testing machine. Herein, a thermal medium, also called a heat transfer medium or a heat transfer agent, is a fluid for transferring heat, including one for cooling and one for heating.

### DESCRIPTION OF THE RELATED ART

Electronic devices as typified by a mobile phone and a personal computer are in widespread use. Recently, these electronic devices are used for various purposes or in various environments. That is why influences on the electronic devices themselves or their components such as integrated circuits affected by such environments should be tested.

A testing machine for exposing these electronic devices or components to a high-temperature or low temperature environment includes one having such a structure as disclosed in patent document 1 (DE 195 40 103).

A testing machine disclosed in the patent document 1 is a device called a wafer probe, which includes a thermostat called a "thermal plate" or a "temperature controlled chuck" and which conducts tests with a semiconductor wafer mounted on or fixed to the thermostat.

The thermostat called a thermal plate or a temperature controlled chuck has a mounting table (or testing table) on which an article to be tested is mounted or to which the article is fixed. In many cases, the thermostat has an electric heater attached thereto and a cavity formed therewithin. The testing machine has therein a piping including at least a pipe for a thermostat for supplying a thermal medium to the cavity A thermal medium at a predetermined temperature is introduced into the cavity via the piping. A heat insulator is attached to the piping so as to prevent heat dissipation from or heat absorption into the piping.

Controlling of the electric heater and operation of introducing the thermal medium into the cavity maintain a desired temperature of the mounting table. In order to lower the temperature of the mounting table, for example, a low-temperature thermal medium is introduced into the cavity via the piping.

The device called a wafer probe is designed to mount a thermostat on an XY table so as to move the thermostat to a predetermined position.

Thus, a piping for a thermostat must run in obedience to movement of the thermostat, so as to be composed of flexible tubes or pipes.

Further, the wafer probe is designed to allow the piping to smoothly run along with the thermostat within the device. The testing machine disclosed in the patent document 1, for example, is designed to apply tension to the piping by means of a spring so as to control balance of the piping.

### SUMMARY OF THE INVENTION

### PROBLEMS TO BE SOLVED BY THE INVENTION

In a testing machine such as a wafer probe, as described above, a heat insulator is attached to a pipe so as to prevent heat dissipation from or heat absorption into the pipe.

However, conventional piping system for a thermostat may have an insufficient insulation.

Specifically, a testing machine such as a wafer probe imposes cold load at around minus 65 degrees Centigrade on a semiconductor wafer on which an electronic circuit is constituted. Therefore, a coolant (thermal medium) at temperature of the above-mentioned load or below is supplied to a cavity in the thermostat.

As just described, temperature of a coolant supplied to a cavity in a thermostat is very different from atmospheric temperature. Thus, a piping system for a thermostat requires strict heat insulation, with a consequence that the conventional configuration may not be enough for the strict insulation.

Further, as described above, there is also a wafer probe having a movable thermostat, with which a piping system must run. However, thickening of a heat insulation layer of the piping system may encumber the piping system.

### MEANS TO SOLVE THE PROBLEM

The present invention takes note of the above-mentioned problems and drawbacks of the conventional art and aims at development of a piping system for a thermostat having good insulation and being easily movable in an apparatus.

An aspect of the present invention is a piping system for supplying a thermal medium to a thermostat and/or for discharging the medium from the thermostat. The piping system includes a flexible pipe for guiding the thermal medium to and/or from the thermostat, a heat insulator, and at least one insulator holder holding the heat insulator, wherein the insulator holder has a fixed portion directly or indirectly fixed to the pipe and a supporting portion located adjacent to the pipe and supporting the heat insulator, and wherein the heat insulator is attached to the supporting portion so as to encircle the pipe maintaining a gap between the heat insulator and the pipe.

In the present invention, the thermostat may have a specific temperature control face and adjust a temperature of the face to a predetermined temperature with the thermal medium introduced into the thermostat. For example, a thermostat having therein a cavity, into which a thermal medium is introduced so as to adjust temperature of a specific temperature-control face, is known.

In the piping system of the present aspect, a heat insulator is attached to a supporting portion supporting the heat insulator, so as to encircle a pipe, and a gap is formed between the heat insulator and the pipe.

Therefore, the piping system of the present aspect has good insulation of the pipe.

Preferably, the piping system further includes a pipe positioner having an elongated flexible member and at least one pipe holder holding the pipe, and the fixed portion of the insulator holder is attached to the elongated flexible member.

The piping system of the preferred aspect further includes a pipe positioner, which has an elongated flexible member and at least one pipe holder holding the pipe. The fixed portion of the insulator holder is attached to the elongated flexible member. Thus, the supporting portion maintains a constant positional relationship with the pipe via the elongated flexible member and is located adjacent to the pipe. In the piping system of the preferred aspect, the heat insulator is attached to the supporting portion, so as to maintain a constant positional relationship with the pipe via the supporting portion and the elongated flexible member. Therefore, a gap formed between the pipe and the heat insulator is maintained even with the pipe slightly bent.

Preferably, the pipe positioner has a plurality of pipe holders holding the pipe, the pipe holders fix the pipe to the elongated flexible member, and the heat insulator is divided at sites corresponding to the pipe holders.

In the piping system of the preferred aspect, the heat insulator is divided at sites corresponding to the pipe holders, so that the piping system is easily bent at the sites. Consequently, the piping system of the preferred aspect is easily bent and movable.

Another aspect of the present invention is a piping system for supplying a thermal medium to a thermostat and/or for discharging the medium from the thermostat. The piping system includes a flexible inlet pipe for guiding the thermal medium to the thermostat, a flexible outlet pipe for guiding the thermal medium from the thermostat, a pipe positioner, a heat insulator, and at least one insulator holder holding the heat insulator, wherein the pipe positioner fixes the inlet and outlet pipes substantially in parallel to each other, wherein the insulator holder has a fixed portion and a supporting portion, the fixed portion being directly or indirectly fixed to at least one pipe selected from the inlet and outlet pipes, and the supporting portion supporting the heat insulator and being located adjacent to the at least one pipe, and wherein the heat insulator is attached to the supporting portion so as to encircle the at least one pipe maintaining a gap between the heat insulator and the at least one pipe.

The piping system of the present aspect includes an inlet pipe and an outlet pipe, which are fixed substantially in parallel to each other, thereby allowing the pipes to be manageable and easily handled.

Preferably, the pipe positioner has an elongated flexible member and at least one pipe holder for holding a pipe, and the fixed portion of the insulator holder is attached to the elongated flexible member.

In the piping system of the preferred aspect, the fixed portion of the insulator holder is attached to the elongated flexible member. Thus, the supporting portion maintains a constant positional relationship with at least one pipe selected from the inlet and outlet pipes via the elongated flexible member and is located adjacent to the at least one pipe.

Further, in the piping system of the preferred aspect, the heat insulator is attached to the supporting portion, so as to maintain a constant positional relationship with the at least one pipe via the supporting portion and the elongated flexible member. Therefore, a gap formed between the at least one pipe and the heat insulator is maintained even with the pipe slightly bent.

Still further, in the piping system of the preferred aspect, the inlet and outlet pipes are integrated via the elongated flexible member, so as to be manageable and easily movable.

Still another aspect of the present invention is a piping system for supplying a thermal medium to a thermostat and/or for discharging the medium from the thermostat. The piping system includes a flexible inlet pipe for guiding the thermal medium to the thermostat, a flexible outlet pipe for guiding the thermal medium from the thermostat, a pipe positioner, a heat insulator, and at least one insulator holder holding the heat insulator, wherein the pipe positioner has an elongated flexible member and at least one pipe holder for holding a pipe, wherein the pipe positioner fixes the inlet and outlet pipes substantially in parallel to the elongated flexible member, wherein the insulator holder has a fixed portion and a supporting portion, the fixed portion being attached to the elongated flexible member, the supporting portion supporting the heat insulator and being located adjacent to at least one pipe selected from the inlet and outlet pipes, and wherein the heat insulator is attached to the supporting portion so as to encircle the at least one pipe maintaining a gap between the heat insulator and the at least one pipe.

In the piping system of the present aspect, a heat insulator is attached to a supporting portion for supporting the heat insulator, so as to encircle at least one pipe selected from an inlet pipe and an outlet pipe, and a gap is formed between the heat insulator and the at least one pipe.

Thus, the piping system of the present aspect has good insulation of the pipe. Further, the gap between the heat insulator and the pipe is maintained even with the pipe moved.

Specifically, the piping system of the present aspect has a pipe positioner, so as to fix the inlet and outlet pipes substantially in parallel to the elongated flexible member. Therefore, the inlet and outlet pipes maintain a constant positional relationship with the elongated flexible member.

Further, in the piping system of the present aspect, a fixed portion of the insulator holder is attached to the elongated flexible member. Consequently, the supporting portion maintains a constant positional relationship with at least one pipe via the elongated flexible member and is located adjacent to the at least one pipe.

Still further, in the piping system of the present aspect, the heat insulator is attached to the supporting portion, so as to maintain a constant positional relationship with the at least one pipe via the supporting portion and the elongated flexible member. Therefore, a gap formed between the pipe and the heat insulator is maintained even with the pipe slightly bent.

Yet further, in the piping system of the present aspect, the inlet and outlet pipes are integrated via the elongated flexible member, so as to be manageable and easily movable.

Preferably, the pipe positioner has a plurality of pipe holders for holding a pipe, the pipe holders fix the at least one pipe to the elongated flexible member, and the heat insulator is divided at sites corresponding to the pipe holders.

In the piping system of the preferred aspect, the heat insulator is divided at sites corresponding to the pipe holders, so that the piping system is easily bent at the sites. Consequently, the piping system of the preferred aspect is easily bent and movable.

Yet another aspect of the present invention is a testing machine, including a thermostat and a housing enclosing the thermostat, wherein the thermostat is connected within the housing to the piping system of the present invention.

The testing machine of the present aspect reduces heat dissipation from or absorption into the pipe to a lower level, so as to supply a thermal medium maintaining a desired temperature to a thermostat. Therefore, the testing machine of the present aspect has a wide operating temperature range.

### ADVANTAGEOUS EFFECT OF THE INVENTION

The piping system for a thermostat of the present invention reduces heat dissipation from or absorption into the pipe to a lower level, so as to supply a thermal medium maintaining a desired temperature to a thermostat. Therefore, the testing machine employing the piping system of the present invention has a wide operating temperature range, achieving a high basic performance.

The testing machine of the present invention conducts tests in a wide temperature range.

### BRIEF DESCRIPTION OF THE DRAWINGS

Fig. 1 is a perspective view of a testing machine of an embodiment of the present invention;
Fig. 2 is a front view of a piping system for a thermostat employed in the testing machine in Fig. 1;
Fig. 3 is a plan view of the piping system in Fig. 2;
Fig. 4 is a cross sectional perspective view of the piping system in Fig. 2;
Fig. 5 is a partly broken perspective view showing an internal structure of the piping system in Fig. 2;
Fig. 6 is a perspective view of a pipe holder:
Figs. 7A and 7B show an insulator holder, Fig. 7A being a front view thereof and Fig. 7B being a side view thereof;
Fig. 8 is a cross section taken along a line A-A in Fig. 2;
Fig. 9 is a cross section taken along a line B-B in Fig. 2;
Fig. 10 is a cross section taken along a line C-C in Fig. 2;
Fig. 11 is a cross section of a modified piping system for a thermostat of the present invention at the same position as in Fig. 9;
Fig. 12 is a cross section of another modified piping system for a thermostat of the present invention at the same position as in Fig. 9;
Fig. 13 is a plan view of still another modified piping system for a thermostat of the present invention;
Fig. 14 is a partly cross sectional perspective view of a piping system for a thermostat of another embodiment of the present invention;
Fig. 15 is a cross section of the piping system taken along a line A-A in Fig. 14;
Fig. 16 is a partly cross sectional perspective view of a piping system for a thermostat of still another embodiment of the present invention;
Fig. 17 is a cross section of the piping system taken along a line A-A in Fig. 16; and
Fig. 18 is a partly cross sectional perspective view of a piping system for a thermostat of yet another embodiment of the present invention.

### DESCRIPTION OF THE PREFERRED EMBODIMENT

Now, embodiments of the present invention will be described in detail below, making reference to the accompanying drawings.

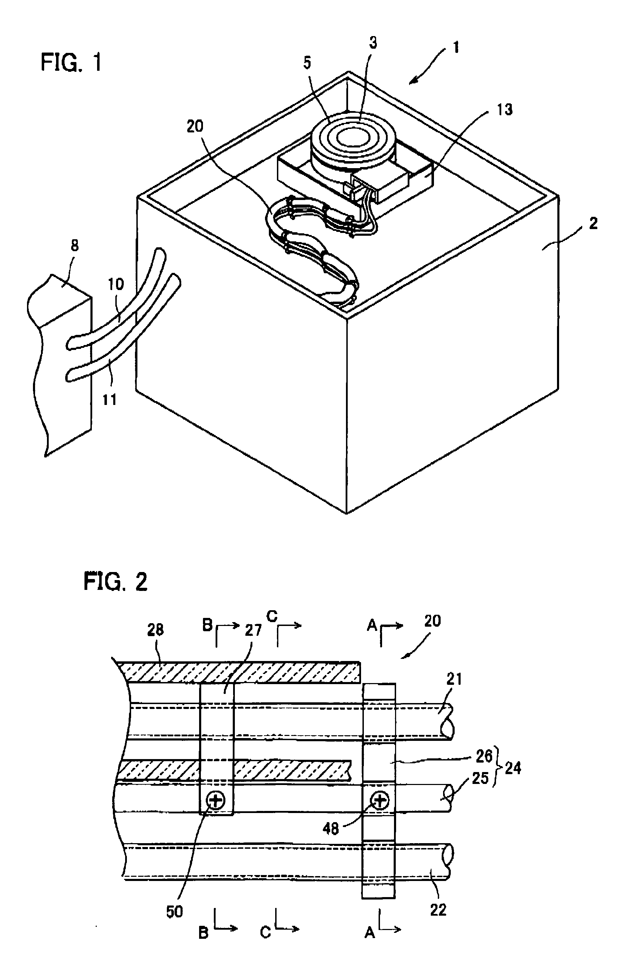

Fig. 1 illustrates a testing machine 1 of an embodiment of the present invention. The testing machine 1 is specifically called a "wafer probe", including a housing 2, in which a thermostat 3 called a "thermal plate" or a "temperature controlled chuck" is enclosed.

The thermostat 3 is of a flat cylindrical shape in appearance and has a top face for mounting thereon an article to be tested. The top face functions as an article mounting table 5, which is controlled to a desired temperature. Specifically, the thermostat 3 has an electric heater not shown and defines therewithin a cavity not shown. Adjusting of the electric heater and circulating of cooled air (thermal medium) into the cavity control the temperature of the mounting table 5.

Further, the thermostat 3 has a vacuum pipe not shown, which serves to hold the article on the mounting table 5 with vacuum.

The thermostat 3 is placed on an XY table 13 and is movable in X and Y directions by a motor not shown.

The testing machine 1 of the present embodiment is designed to introduce cooled air into the thermostat 3 upon reception of cooled air supply from a coolant supplier 8 provided outside the housing 2. The testing machine 1 is connected by a pair of connecting pipes 10 and 11 to the coolant supplier 8. The connecting pipe 10 serves to supply cooled air produced in the coolant supplier 8 into the housing 2, whereas the connecting pipe 11 serves to return air discharged from the cavity back from the housing 2 to the coolant supplier 8.

The housing 2 of the testing machine 1 has therein a piping system 20 for a thermostat. The piping system 20 is composed of an integrated combination of an inlet pipe (or tube) 21 and an outlet pipe (or tube) 22, as described below.

In the housing 2, the connecting pipe 10 described above is connected to the inlet pipe 21 of the piping system 20, whereas the connecting pipe 11 described above is connected to the outlet pipe 22 of the piping system 20.

The cooled air having been produced in the coolant supplier 8 flows through the connecting pipe 10 into the housing 2, then flowing through the inlet pipe 21 of the piping system 20 into the cavity in the thermostat 3. On the other hand, the air having been discharged from the cavity flows through the outlet pipe 22 of the piping system 20 out of the housing 2, then flowing through the connecting pipe 11 back to the coolant supplier 8.

The above-mentioned description gives a rough outline of the testing machine 1 of the present embodiment. Especially, the testing machine 1 employs the unique piping system 20. Hereafter, the piping system 20 will be described.

The piping system 20 employed in the present embodiment, as shown in Fig. 2, mainly consists of the inlet pipe 21, the outlet pipe 22, a pipe positioner 24, a plurality of insulator holders 27, and a plurality of heat insulating sections (also called heat insulating pieces) 28. The pipe positioner 24 includes a wire (elongated flexible member) 25 and a plurality of pipe holders 26.

Among the above-mentioned members, there are one inlet pipe 21, one outlet pipe 22, and one wire 25 in one testing machine 1.

In contrast, there are a number of pipe holders 26, a number of insulator holders 27, and a number of heat insulating sections 28.

The inlet pipe 21 is a flexible tube. Since low-temperature air flows through the inlet pipe 21, a tube made of a material preserving elasticity at a considerable low temperature is selected as the inlet pipe 21.

The outlet pipe 22 is also a flexible tube. Since the same can be said to the outlet pipe 22, it is preferable to use a tube made of a material as just described.

The wire 25 has a plurality of pipe holder mounting holes (not shown) and a number of insulator holder mounting holes (not shown) at predetermined intervals.

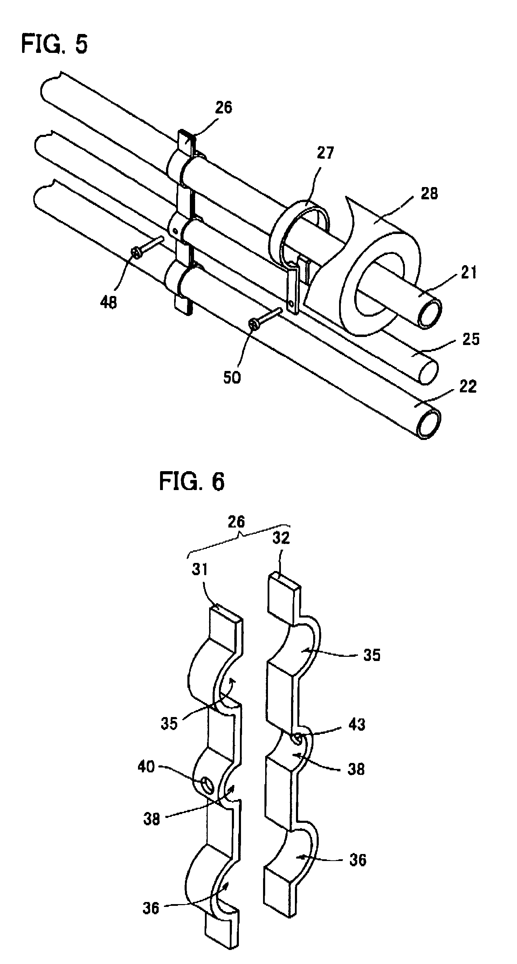

The pipe holders 26 each are, as shown in Fig. 6, composed of two holder pieces 31 and 32 in pairs.

The holder piece 31 is made of metal or resin and has two pipe holding portions 35 and 36, each of which is specifically of a semicircular concave portion.

Further, the holder piece 31 has a wire holding portion 38 between the pipe holding portions 35 and 36 and an unthreaded throughhole 40 penetrating through both sides at the portion 38.

The holder piece 32 is symmetric to and made of the same material as the above-mentioned holder piece 31, and similarly thereto, has two pipe holding portions 35 and 36 and a wire holding portion 38 therebetween. Though the above-mentioned holder piece 31 has the throughhole 40 at the portion 38, the holder piece 32 has a threaded hole 43 at the same position as the unthreaded throughhole 40.

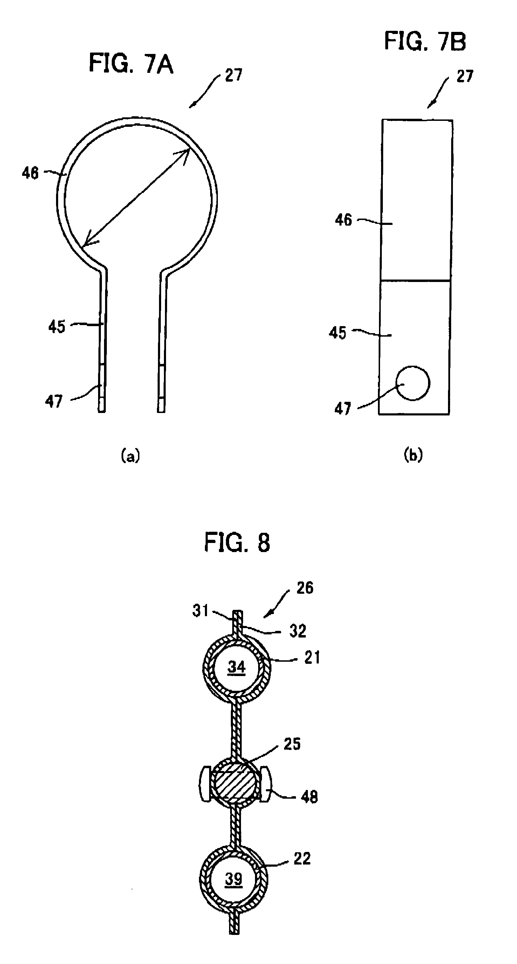

Each of the insulator holders 27 is produced by curving a band made of a material such as stainless steel, and as shown in Fig. 7, includes a fixed portion 45 (i.e., a portion where the holder 27 is to be fixed to another member such as the wire 25) with two plates arranged at opposed positions and a supporting portion 46 being annularly continuous to the fixed portion 45. Herein, the supporting portion 46 is of a circular shape with an inner diameter quite larger than an outer diameter of the inlet pipe 21, More specifically, the inner diameter of the supporting portion 46 is larger than the outer diameter of the inlet pipe 21 by about 2 to 10 mm.

The fixed portion 45 has a pair of unthreaded throughholes 47 penetrating the both plates.

The heat insulating sections 28 each are made of a material such as glass wool or resin foam heretofore known. The heat insulating sections 28 each may be a rolled mat-like material or a molded material into a "C-shaped" cross section (circular shape with a part cut away).

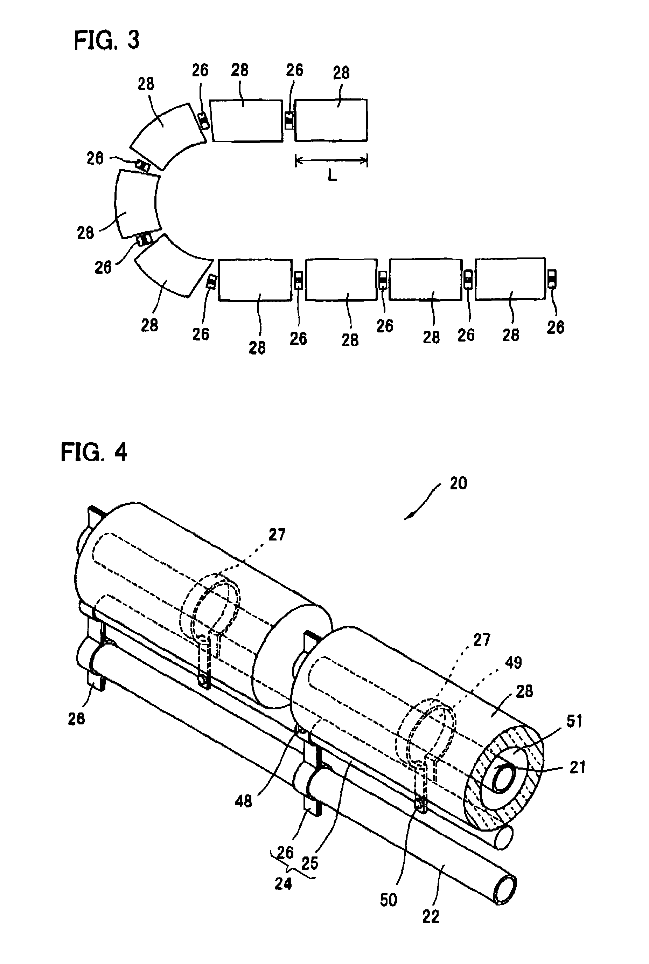

The heat insulating sections 28 each have a length "L" (Fig. 3) being relatively short and substantially equal to a distance between each adjoining pair of the pipe holders 26.

Now, relationship between members constituting the piping system 20 will be described below.

The piping system 20 of the present embodiment is built around the wire (elongated flexible member) 25. The inlet pipe 21 and the outlet pipe 22 are fixed to both sides of (over and below in the figure) the wire 25 in parallel to each other via the pipe holders 26. The insulator holders 27 are attached to the wire 25 and the heat insulating sections 28 are attached to the insulator holders 27.

Referring to Figs. 1 and 3, a plurality of pipe holders 26 are attached to the wire 25 at predetermined intervals. Each pipe holder 26 sandwiches the wire 25 between the wire holding portions 38 of the holder pieces 31 and 32. Besides, a screw 48 is inserted into the throughhole 40 and the threaded hole 43 of the wire holding portions 38 and the pipe holder mounting holes of the wire 25 so as to fix the wire 25 to the pipe holder 26.

Then, as shown in Fig. 8, the inlet pipe 21 is inserted in a circular space 34 formed by the holder pieces 31 and 32 of the pipe holders 26, whereas the outlet pipe 22 is inserted in the other circular space 39 formed by the holder pieces 31 and 32.

Now, a mounting arrangement of the insulator holders 27 will be described below. The insulator holders 27 each are fixed to the wire 25 by means of a screw 50 so as to sandwich the wire 25 between the two plates of the fixed portion 45.

The annular supporting portion 46 of the insulator holder 27 is, as shown in Figs. 4 and 5, located adjacent to the inlet pipe 21, and more specifically, encircles the inlet pipe 21. In other words, the inlet pipe 21 is located in the center of the supporting portion 46. As described above, since the inner diameter of the supporting portion 46 is larger than the outer diameter of the inlet pipe 21, a gap 49 exists between the inlet pipe 21 and the supporting portion 46, as shown in Figs. 4 and 5.

The heat insulating sections 28 each are positioned at the outer side of the supporting portion 46. That forms a cylindrical gap 51 between the inlet pipe 21 and the inner surface of the heat insulating section 28.

The gap 51 exists over a full length of the inlet pipe 21 except parts where the pipe holders 26 are positioned.

The length "L" of the heat insulating section 28 is substantially equal to the distance between each adjoining pair of the pipe holders 26, as described above, so that the heat insulating section 28 fits in between the pair of the pipe holders 26. Herein, the heat insulating section 28 is sealed at its both ends so as to prevent cooled air from escaping therefrom.

The piping system 20 is fixed to the housing 2 at its proximal end, to which the connecting pipes 10 and 11 are connected via communicating pipes not shown. Further, the piping system 20 is connected to the cavity in the thermostat 3 at its distal end. Though the proximal end of the piping system 20 is fixed to the housing 2 and the distal end of the piping system 20 is attached to the thermostat 3, an intermediate part of the piping system 20 between the proximal and distal ends are free (i.e., not attached to any other member).

As for air flow, an air at low temperature passes through the inlet pipe 21 of the piping system 20 to be supplied to the cavity in the thermostat 3. The air having flown from the cavity passes through the outlet pipe 22 of the piping system 20, so as to be discharged.

Herein, the piping system 20 of the present invention has the heat insulating sections 28 attached to the inlet pipe 21, through which low temperature air passes. Further, in the present embodiment, the cylindrical gap 51 exists between the inlet pipe 21 and each of the heat insulating sections 28. Still further, the both ends of each of the heat insulating sections 28 are sealed, so as to prevent air enclosed within the gap 51 from escaping from the gap 51. Consequently, the gap 51 around the inlet pipe 21 functions as a heat-insulating air layer. Thus, in the piping system 20 of the present embodiment, the inlet pipe 21 is thermally insulated from outside by the heat-insulating air layer and the heat insulating sections 28, so that cold of air flowing through the inlet pipe 21 hardly escapes therefrom.

In the case of operating the XY table 13, the piping system 20 is moved along with the movement of the thermostat 3 mounted on the XY table 13. That variedly bends the piping system 20, but the gap 51 (i.e., a heat insulating layer) is maintained in any situation.

More specifically, in the piping system 20 of the present embodiment, the inlet pipe 21 is fixed in parallel to the wire 25 by means of the pipe holders 26, so as to be kept in a given position relative to the wire 25 even when the piping system 20 changes its position.

The fixed portions 45 of the insulator holders 27 are attached to the wire 25. Thereby, the supporting portions 46 of the insulator holders 27 maintain constant positional relationships relative to the inlet pipe 21 via the wire 25, even when the piping system 20 changes its position.

Therefore, even when the piping system 20 moves and changes its bent shape, the positional relationships between the inlet pipe 21 and the supporting portions 46 have no change and the gap 51 (i.e., the heat insulating layer) is maintained.

Consequently, even when the piping system 20 moves, insulation effectiveness stays unchanged and cold is not diffused from the inlet pipe 21.

Further, the piping system 20 of the present embodiment combines the inlet and outlet pipes 21 and 22 via the wire 25, so as to be manageable and easily movable.

In addition, a heat insulator used in the present embodiment is constituted by a plurality of discrete heat insulating sections 28. In other words, the heat insulator is divided into several pieces at positions corresponding to the pipe holders 26, thereby facilitating bending of the piping system 20 adjacent to the pipe holders 26. Therefore, the pipe positioner 24 can be bent into a "U" (horseshoe) shape or an "S" shape, or even intricately in a serpentine shape.

Still further, the wire 25 has a certain level of flexibility, thereby maintaining a constant curvature at parts where the piping system 20 is bent and avoiding the piping system 20 from kinking even when the piping system 20 moves and changes its bent shape.

Thus, with movement of the thermostat 3, the piping system 20 smoothly keeps up.

Then, modified embodiments of the present invention will be described below.

The above-mentioned embodiment has such a structure that the insulator holders 27 each have the annular supporting portion 46, which completely encircles the inlet pipe 21. However, the present invention is not limited to this structure, and may have various modified embodiments.

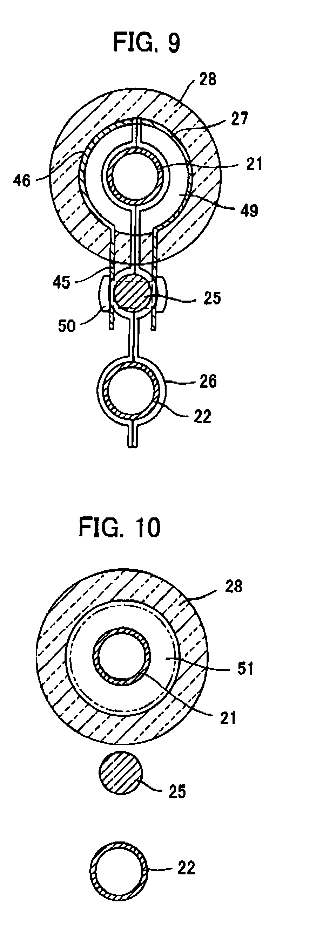

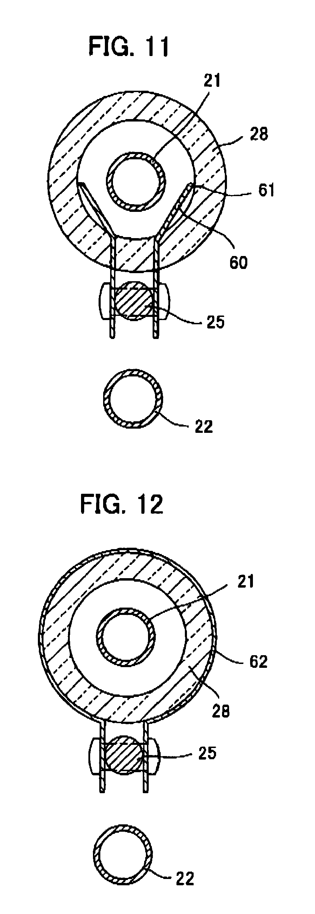

Fig. 11 is a cross section of a modified piping system for a thermostat of the present invention at the same position as in Fig. 9. Fig. 12 is a cross section of another modified piping system for a thermostat of the present invention at the same position as in Fig. 9.

Specifically, the supporting portions 46 each are not necessarily be of a circular shape, and are not required to be even annularly. As in an insulator holder 60 shown in Fig. 11, for example, the insulator holder 60 may have a pair of cantilevered supporting portions 61 so as to support the heat insulating section 28 by tips of the portions 61. The insulator holder 60 shown in Fig. 11 is of a "Y" shape, but may be of a "T" shape or a "C" shape (circular shape with a part cut away).

In the foregoing embodiments, the supporting portions 27 and 61 each have the heat insulating section 28 attached to the outer side thereof, but as shown in Fig. 12, the heat insulating section 28 may be supported inside of an insulator holder 62.

The foregoing embodiments each use a wire as the elongated flexible member, but may use a linear or band-like elongated flexible member.

Further, in the foregoing embodiments, the pipe holders 26 are arranged at substantially regular intervals, but may be arranged at discretional intervals. Consequently, length of a heat insulating section 28 arranged between each adjoining pair of the pipe holders 26 may be discretionally determined.

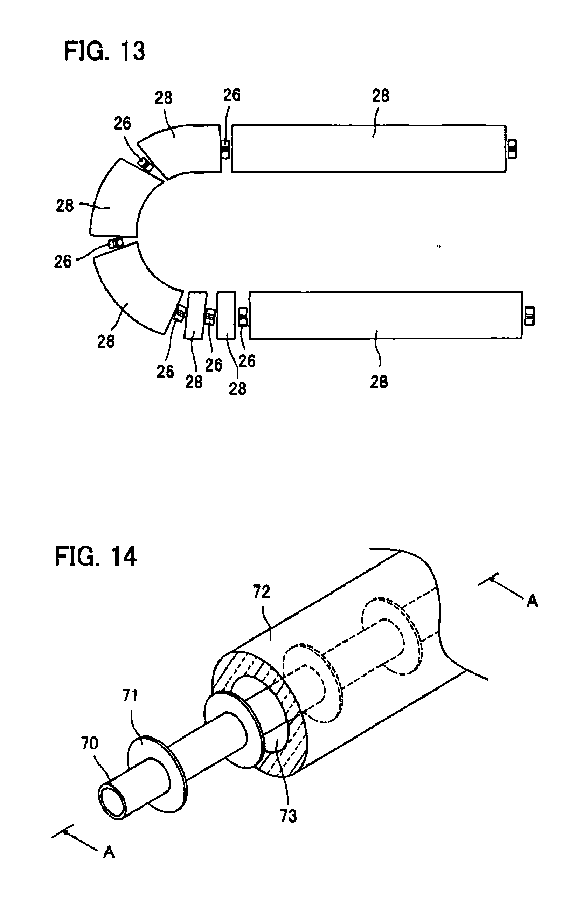

Fig. 13 is a plan view of still another modified piping system for a thermostat of the present invention. As shown in Fig. 13, the pipe holders 26 may be arranged at irregular intervals. Specifically, in the piping system 20, an interval between each adjoining pair of the pipe holders 26 at a part to be curved is decreased, whereas an interval therebetween at a part to be arranged straightly is lengthened. As a consequence, a part having a short interval between the pipe holders 26 has a small curvature radius and a part having a long interval therebetween has a large curvature radius.

Still further, in the foregoing embodiments, a wire is used as the elongated flexible member, but may use a band-like material instead thereof, A band or a band-like material has second moment of area in a vertical direction extremely different from that in a horizontal direction. A band is flexible to one side (in a thickness direction), but is inflexible in a width direction. Thus, when being set upright in the width direction, a band-like elongated flexible member is easily bent on a horizontal plane and hardly bent on a vertical plane. Therefore, the piping system is restricted to move on one plane.

Yet further, in the foregoing embodiments, the fixed portion 45 of the insulator holder 27 is indirectly fixed to the inlet pipe 21 via the elongated flexible member such as a wire, but may be directly fixed thereto.

Figs. 14 to 18 show other modified embodiments each in which an insulator holder is directly fixed to a pipe.

A piping system shown in Fig. 14 includes an inlet pipe 70, insulator holders 71, and heat insulating sections 72. In the present embodiment, the insulator holders 71 each are a circular plate having a circular hole in the center thereof, in which the inlet pipe 70 is inserted. In the present embodiment, the central circular hole functions as a fixed portion (i.e., a portion where the holder 71 is to be fixed to the inlet pipe 70) and a peripheral portion of the circular plate functions as a supporting portion.

Specifically, the heat insulating sections 72 each are attached to the outer side of the insulator holder 71, with an annular gap 73 between the inlet pipe 70 and the inner surface of the heat insulating section 72.

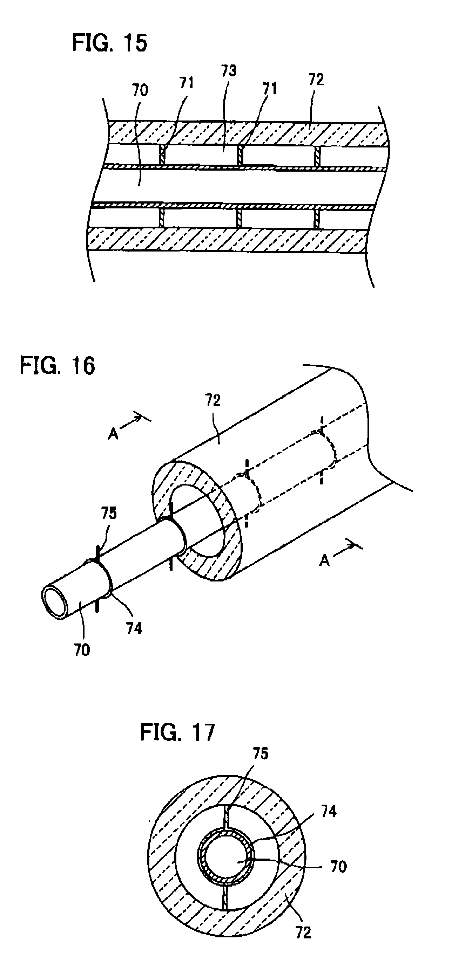

The embodiments shown in Figs. 14 and 15 uses a circular plate-like member as the insulator holder 71, but the present invention is not limited thereto. It is enough only to have a fixed portion to be fixed to the inlet pipe 70 and a portion (supporting portion) to support a heat insulator. As shown in Figs. 16 and 17, for example, an insulator holder may have a fixed portion 74 of an annular shape and supporting portions 75 of pin-like shapes so as to hold a heat insulating section 72 by means of tips of the pin-like shapes.

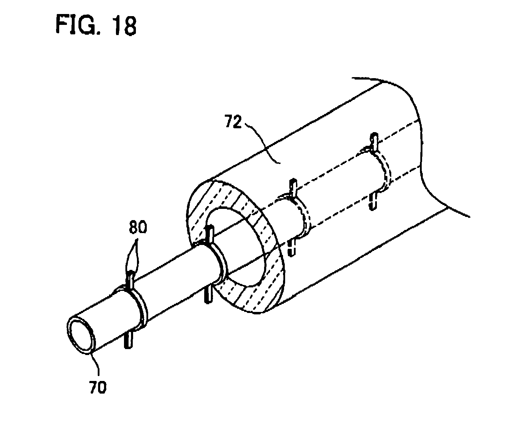

Further, as shown in Fig. 18, an insulator holder 80 may have two pieces of plates having each a curved portion and two projecting portions and sandwiching an inlet pipe 70 so as to be fixed to the inlet pipe 70.

In the above-mentioned embodiments, the insulator holders and the heat insulator are arranged only at the inlet pipe, but may be arranged only at the outlet pipe or may be arranged at both the inlet and outlet pipes.

Further, in the above-mentioned embodiments, the thermal medium is a coolant, but of course may be a medium for heating.

## Claims

1. A piping system for supplying a thermal medium to a thermostat and/or for discharging the medium from the thermostat,
comprising a flexible pipe for guiding the thermal medium to and/or from the thermostat, a heat insulator, and at least one insulator holder holding the heat insulator,
wherein the insulator holder has a fixed portion directly or indirectly fixed to the pipe and a supporting portion located adjacent to the pipe and supporting the heat insulator, and
wherein the heat insulator is attached to the supporting portion so as to encircle the pipe maintaining a gap between the heat insulator and the pipe.

2. The piping system as defined in claim 1, further comprising a pipe positioner having an elongated flexible member and at least one pipe holder holding the pipe, and
wherein the fixed portion of the insulator holder is attached to the elongated flexible member.

3. The piping system as defined in claim 2,
wherein the pipe positioner has a plurality of pipe holders holding the pipe,
wherein the pipe holders fix the pipe to the elongated flexible member, and
wherein the heat insulator is divided at sites corresponding to the pipe holders.

4. A piping system for supplying a thermal medium to a thermostat and/or for discharging the medium from the thermostat,
comprising a flexible inlet pipe for guiding the thermal medium to the thermostat, a flexible outlet pipe for guiding the thermal medium from the thermostat, a pipe positioner, a heat insulator, and at least one insulator holder holding the heat insulator,
wherein the pipe positioner fixes the inlet and outlet pipes substantially in parallel to each other,
wherein the insulator holder has a fixed portion and a supporting portion,
the fixed portion being directly or indirectly fixed to at least one pipe selected from the inlet and outlet pipes, and
the supporting portion supporting the heat insulator and being located adjacent to the at least one pipe, and
wherein the heat insulator is attached to the supporting portion so as to encircle the at least one pipe maintaining a gap between the heat insulator and the at least one pipe.

5. The piping system as defined in claim 4,
wherein the pipe positioner has an elongated flexible member and at least one pipe holder for holding a pipe, and
wherein the fixed portion of the insulator holder is attached to the elongated flexible member.

6. The piping system as defined in claim 5,
wherein the pipe positioner has a plurality of pipe holders for holding a pipe,
wherein the pipe holders fix the at least one pipe to the elongated flexible member, and
wherein the heat insulator is divided sites corresponding to the pipe holders.

7. A piping system for supplying a thermal medium to a thermostat and/or for discharging the medium from the thermostat,
comprising a flexible inlet pipe for guiding the thermal medium to the thermostat, a flexible outlet pipe for guiding the thermal medium from the thermostat, a pipe positioner, a heat insulator, and at least one insulator holder holding the heat insulator,
wherein the pipe positioner has an elongated flexible member and at least one pipe holder for holding a pipe,
wherein the pipe positioner fixes the inlet and outlet pipes substantially in parallel to the elongated flexible member,
wherein the insulator holder has a fixed portion and a supporting portion,
the fixed portion being attached to the elongated flexible member,
the supporting portion supporting the heat insulator and being located adjacent to at least one pipe selected from the inlet and outlet pipes, and
wherein the heat insulator is attached to the supporting portion so as to encircle the at least one pipe maintaining a gap between the heat insulator and the at least one pipe.

8. The piping system as defined in claim 7,
wherein the pipe positioner has a plurality of pipe holders for holding a pipe,
wherein the pipe holders fix the at least one pipe to the elongated flexible member, and
wherein the heat insulator is divided at sites corresponding to the pipe holders.

9. A testing machine, comprising a thermostat and a housing enclosing the thermostat,
wherein the thermostat is connected within the housing to the piping system as defined in claim 1.

10. A testing machine, comprising a thermostat and a housing enclosing the thermostat,
wherein the thermostat is connected within the housing to the piping system as defined in claim 2.

11. A testing machine, comprising a thermostat and a housing enclosing the thermostat,
wherein the thermostat is connected within the housing to the piping system as defined in claim 3.

12. A testing machine, comprising a thermostat and a housing enclosing the thermostat,
wherein the thermostat is connected within the housing to the piping system as defined in claim 4.

13. A testing machine, comprising a thermostat and a housing enclosing the thermostat,
wherein the thermostat is connected within the housing to the piping system as defined in claim 5.

14. A testing machine, comprising a thermostat and a housing enclosing the thermostat,
wherein the thermostat is connected within the housing to the piping system as defined in claim 6.

15. A testing machine, comprising a thermostat and a housing enclosing the thermostat,
wherein the thermostat is connected within the housing to the piping system as defined in claim 7.

16. A testing machine, comprising a thermostat and a housing enclosing the thermostat,
wherein the thermostat is connected within the housing to the piping system as defined in claim 8.
